# EUROPEAN PATENT APPLICATION

(11) **EP 2 482 330 A2**
(43) Date of publication of application: **01.08.2012**
(21) Application number: 12150940.0
(22) Date of filing: 12.01.2012
(51) Int. Cl.: H01L 31/0376, H01L 31/0236

(54) **Light-trapping layer for thin-film silicon solar cells**

(30) Priority: 27.01.2011 IN 1900042011
(71) Applicant: Moser Baer India Ltd., New Dehli 110020 (IN)
(72) Inventor: Steltenpool, Mark, 110020 New Dehli (IN); Van Erven, Rob, 110020 New Dehli (IN)
(74) Representative: Beck & Rössig European Patent Attorneys

(57) **Abstract**

A light trapping layer (104) for use in a thin film solar cell is provided. The light trapping texture enhances efficiency of the thin film solar cell. The light trapping layer (104) has a plurality of substantially flat areas between a plurality of periodically repeating non-pointed depressions with rounded edges (504). The plurality of substantially flat areas (502) facilitates deposition and growth of a layer (108) of transparent conductive oxide over said light trapping layer. The plurality of periodically repeating non-pointed depressions with rounded edges (504) limit formation of at least one of cracks, voids, and low density areas in semiconductor layers of the thin film solar cell. Period of the non-pointed depressions (504) ranges between 100 nanometers and 1500 nanometers, and depth of said non-pointed depressions ranges (504) between 50 nanometers and 1200 nanometers.

## Description

### FIELD OF INVENTION

The invention disclosed herein relates, in general, to photovoltaic devices such as solar cells. More specifically, the present invention relates to thin film solar cells.

### BACKGROUND

Photovoltaic devices such as, solar cells, convert solar radiations into electric power. Efficiency of the photovoltaic devices is significantly determined by their ability to capture maximum amount of incident solar light. In general, to increase the absorption of incident solar light, light trapping textures are used in a thin film solar cell.

Further, for crystalline silicon solar cells, an antireflection coating is applied or texturing of the surface of crystalline silicon solar cell is done to enhance the absorption of incident light. However, in case of thin film solar cells, efficiency is enhanced by providing a random nano-texture with a texture size of around 50-200 nm on substrates or superstrates of the thin film solar cells. This random nano-texture scatters the incident light, and hence, increases the optical path length of light, and this leads to more absorption of light by the semiconductor layers of the thin film solar cells.

However, it is difficult to optimize parameters of these random nano-textures independently, as parameters of these random nano-textures are dependent on the type of materials used and the process parameters. As a result, it is not possible to independently optimize the random nano-texture parameters for maximum light-trapping in a given solar cell layer stack design.

Also, TCO growth on such nano-structures is not straightforward and can result in cracks, voids or low density area's in both TCO and semiconductor layers of thin film solar cell.

In light of the above discussion, there is a need for an improvement in the current thin film solar cells in order to eliminate the drawbacks of the prior art.

### SUMMARY

An object of the present invention is to provide a light trapping layer that facilitates deposition and growth of transparent conductive oxide over the light trapping layer.

Another object of the present invention is to provide a light trapping layer that improves and enhances the efficiency and quality of the thin film solar cell.

Yet another object of the present invention is to provide a light trapping layer that limits formation of cracks, voids, and low density areas in semiconductor layers of the thin film solar cell.

The invention provides a light trapping layer for use in a thin film solar cell.

Some embodiments of the present invention provide a method for manufacturing a photovoltaic device.

In some embodiments, a light trapping layer for use in a thin film solar cell is provided. The light trapping texture enhances the efficiency of the thin film solar cell. The light trapping layer has a plurality of substantially flat areas between a plurality of periodically repeating non-pointed depressions with rounded edges. The plurality of substantially flat areas facilitates deposition and growth of a layer of transparent conductive oxide with sufficient conductivity on said light trapping layer. The plurality of periodically repeating non-pointed depressions with rounded edges limits the formation of at least one of cracks, voids, and low density areas in semiconductor layers of the thin film solar cell. Period of the non-pointed depressions ranges between 100 nanometers and 1500 nanometers, and depth of said non-pointed depressions ranges between 50 nanometers and 1200 nanometers.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1 is a diagrammatic illustration of various components of an exemplary photovoltaic device according to an embodiment of the present invention;
FIGs. 2a and 2b are diagrammatic illustrations depicting texture formed on a layer of curable material according to the prior art;
FIG. 3 depicts the defect that are created in the TCO layer in accordance with the prior art;
FIG. 4 is diagrammatic illustration depicting texture formed on a layer of curable material in accordance with the current invention;
FIG. 5 is a diagrammatic illustration depicting geometry of the texture formed on the layer of curable material in accordance with the current invention;
FIG. 6 is a diagrammatic illustration depicting geometry of the texture formed on the layer of curable material in accordance with an embodiment of the current invention;
FIGs. 7a and 7b depict the texture formed on the layer of curable material in accordance with some embodiments of the current invention ;
FIG. 8 is a diagrammatic illustration depicting the texture formed on the layer of curable material in accordance with an embodiment of the current invention; and
FIG. 9 is a flow chart describing an exemplary method for manufacturing the photovoltaic device in accordance with an embodiment of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### DESCRIPTION OF THE EXEMPLARY EMBODIMENTS

The instant exemplary embodiments provide a light trapping layer for use in a thin film solar cell.

Before describing the present invention in detail, it should be observed that the present invention utilizes a combination of method steps and apparatus components related to a light trapping layer for use in a thin film solar cell. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

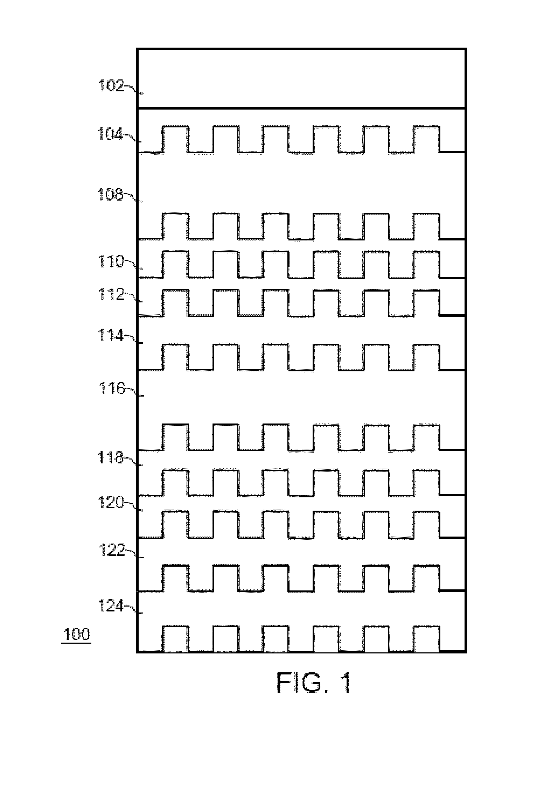

Referring now to the drawings, there is shown in FIG. 1, a diagrammatic illustration of various components of an exemplary photovoltaic device 100 according to an embodiment of the present invention. Examples of the photovoltaic device 100 include, but are not limited to, a thin film solar cell, an organic solar cell, an amorphous silicon solar cell, a microcrystalline silicon solar cell, a micromorph silicon tandem solar cell, a Copper Indium Gallium Selenide (CIGS) solar cell, a Cadmium Telluride (CdTe) solar cell, and the like. The photovoltaic device 100 is shown to include a stack of a substrate 102, a layer of curable material 104, a first layer 108 of TCO, multiple semiconductor layers 110, 112, 114, 116 and 118, a second layer 120 of TCO, a layer 122 of silver, and a layer 124 of aluminum.

The substrate 102 provides strength to the photovoltaic device 100 and is used as a starting point for deposition of other layers that constitute the photovoltaic device 100. An example of a material of the substrate 102 includes, but is not limited to, glass and transparent plastics. In some exemplary embodiments, during real life applications, the photovoltaic device 100 is placed in a way that the substrate 102 is facing the sun and all the sun light falling on the photovoltaic device 100 is incident on the substrate 102. In these embodiments, the substrate 102 is made of a transparent material so that it allows maximum light to pass through itself and reach the subsequent layers. The substrate 102 includes a flat surface on which other subsequent layers can be deposited.

Moving on to the layer of the curable material 104. The layer of curable material 104 is deposited over the substrate 102. The curable material should be able to retain any nano-texture embossed on it when it is cured by using mediums such as heat or light. The curable material can include, but is not limited to, a ultra-violet curable material, a photo-polymer lacquer, an acrylate, and silica or silica-titania based sol-gel materials.

In accordance with the present invention, the layer of curable material 104 is deposited in a manner such that a texture is formed on a surface of the layer of the curable material 104. The examples of the texture include, but are not limited to, ID or 2D periodic U-shaped features, a ID or 2D periodic sinusoidal grating, ID or 2D periodic inverted pyramids, and ID or 2D periodic inverted cones. This texture is such that it that enables and enhances light trapping capability of semiconductor layers of the photovoltaic device 100. This texture helps in scattering and diffraction of the light and thus, enhances the light path through the photovoltaic device 100 and hence, enhances the chance of absorption of light by the semiconductor layers of the photovoltaic device 100. Therefore, the texture can also be called light trapping texture and as this texture is formed on the layer of curable material 104, therefore, the layer 104 can be called light trapping layer.

Several methods can be used to create the texture on the layer of curable material 104 that enables light trapping. In one embodiment, the texture can be created by applying a thin layer of the curable material 104, such as a photo-polymer lacquer or a sol-gel material, onto the substrate 102 and then pressing a stamper with the nano-textured surface into this layer 104. Further, a UV curing process is applied to freeze the nano-texture on the layer of the curable material 104.

In another embodiment, the texture can be created by applying a thin layer of the thermally curable material 104, such as a photo-polymer lacquer or a sol-gel material, onto the substrate 102 and then pressing a stamper with the nano-textured surface into this layer 104. Further, heat is applied to the layer 104 in order to freeze the nano-texture on the layer of the curable material 104.

In yet another embodiment, the texture can be created by pressing the stamper against the substrate 102 while it is being heated above its deformation (glass transition) temperature (hot-embossing), followed by a rapid cooling process. Following this, the layer of curable material 104 is deposited on the substrate 102. In another embodiment, the texture can be created by use of injection molding technique. In this embodiment, an injection molding die is mounted on the surface of the substrate 102 and the texture is formed by injecting the curable material in the injection molding die.

Moving on to the first layer 108 of TCO. The first layer 108 of TCO is deposited over the layer of curable material 104. TCOs are doped metal oxides used in photovoltaic devices. Examples of TCOs include, but are not limited to, Aluminum-doped Zinc Oxide (AZO), Boron doped Zinc Oxide (BZO), Gallium doped Zinc Oxide (GZO), Fluorine doped Tin Oxide (FTO) and Indium doped Tin Oxide (ITO). TCOs have more than 80% transmittance of incident light and have conductivities higher than 10³ S/cm for efficient carrier transport. The transmittance of TCOs, just as in any transparent material, is limited by light scattering at defects and grain boundaries.

Next set of layers in the stack of photovoltaic device 100 are semiconductor layers 110, 112, 114, 116, and 118. Generally, the semiconductor layers are deposited using Plasma Enhanced Chemical Vapor Deposition (PECVD), sputtering, and hot wire techniques on the first layer 108 of TCO. For the purpose of this description, the semiconductor layers are shown to include a first layer of p-doped semiconductor 110, a second layer of p-doped semiconductor 112, a layer of buffer 114, a layer of i-doped semiconductor 116, and a layer of n-doped semiconductor 118. However, it will be readily apparent to those skilled in the art that the photovoltaic device 100 include or exclude one or more semiconductor layers without deviating from the scope of the invention.

For the purpose of this description, the first layer of p-doped semiconductor 110 is made of µc-Si:H. However, the second layer of p-doped semiconductor 112, the layer of i-doped semiconductor 116, and the layer of n-doped semiconductor 118 are made of a-Si:H.

In general, when glass is used as a superstrate or substrate, the semiconductor layers are deposited in a p-i-n sequence, i.e. p-doped semiconductor, i-doped semiconductor, and n-doped semiconductor. This is because the mobility of electrons in a-Si:H is nearly twice than that of holes in aSi:H, and thus the collection rate of electrons moving from the p- to n-type contact is better as compared to holes moving from p- to n-type contact. Therefore, the p-doped semiconductor layer is placed at the top where the intensity of light is more.

Following the semiconductor layers, a cover substrate is deposited. In one embodiment, the cover substrate includes the second layer 120 of TCO, the layer 122 of silver, and the layer 124 of aluminum. In other embodiments, the cover substrate can include at least one of the second layer 120 of TCO, the layer 122 of silver, and the layer 124 of the aluminum. These layers individually or in combination form the back contact of the photovoltaic device 100. In some cases, commercially available photovoltaic device 100 may have additional layers to enhance their efficiency or to improve the reliability.

All the above mentioned layers are encapsulated using an encapsulation to obtain the photovoltaic device 100.

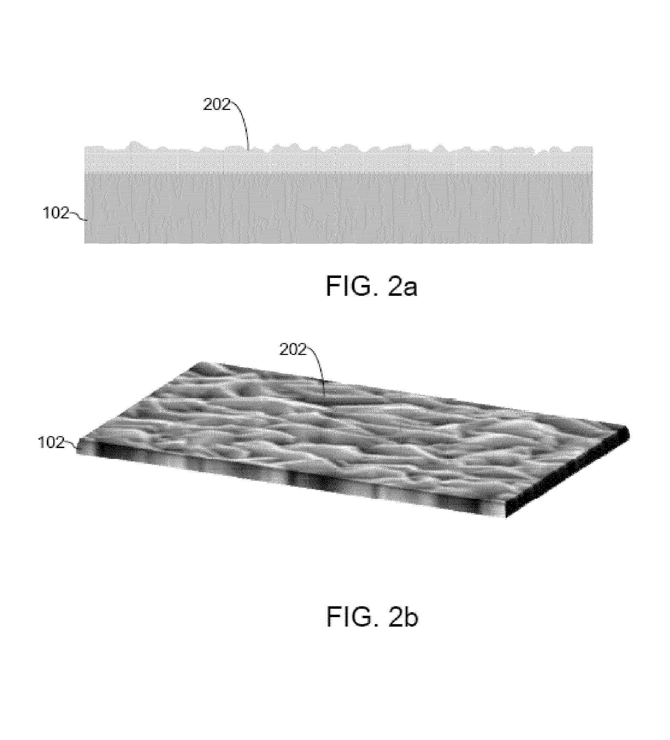

In the prior art, as depicted in FIGs. 2a and 2b, an as grown random textured transparent conductive oxide 202 is deposited on the substrate 102. These random textures 202 are formed during specific deposition conditions of the transparent conductive oxide layer on the substrate 102. Further, deposition of these random textures 202 generally don't require use of methods, such as lithography and stamping, mentioned in FIG. 1 because these random textures 202 are formed as grown on the substrate 102. These random textures 202 improve the efficiency of the photovoltaic device 100 by increasing optical path of light and through scattering. The problem with these random textures 202 is that the feature size and geometry of these random textures 202 is difficult to control during the growth the first layer 108 of TCO. Especially in the case of tandems with a broad spectral range, these random textures 202 are difficult to optimize. Apart from this, these random textures 202 also have tendency to create defects due to the sharp features on subsequent semiconductor layers 110, 112, 114, 116 and 118.

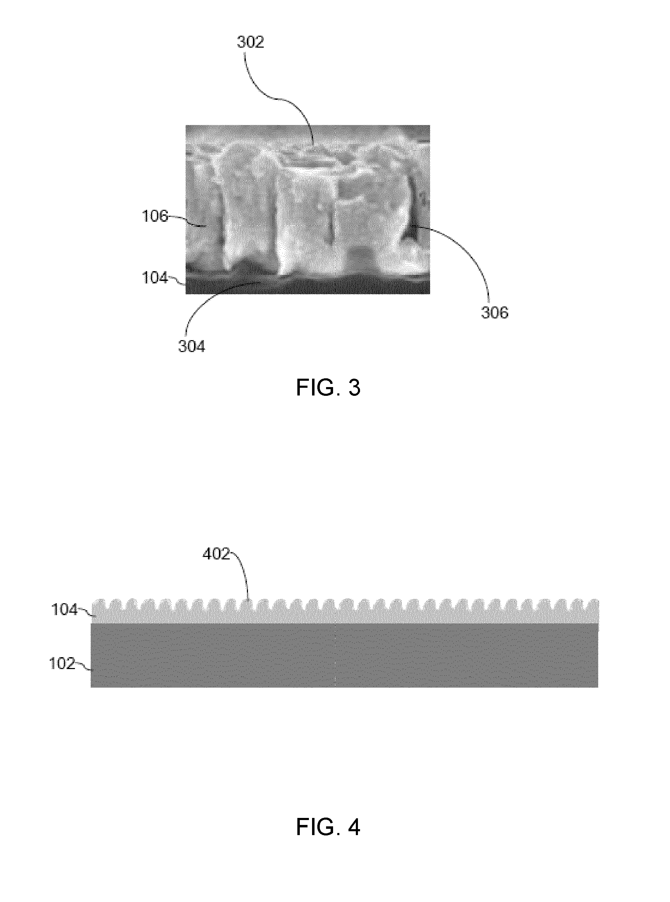

FIG. 3 depicts a type of defect that is created in the first layer 108 of TCO because of the non optimal geometry of the periodic texture202. In this case, the light trapping layer of curable material 104 gets completely leveled, as shown in 304, and loses its functionality completely. In some cases, when the first TCO layer material 108 is deposited through sputtering, flat areas between upright features of the layer of curable material 104 receive less TCO material, thus resulting in thinner layers of TCO with high sheet resistance. Therefore, thicker layers are required but TCO mainly grows on upright feature which acts as nucleation center. When TCO is thick enough for TCO features to connect, low density areas or voids 306 are included and "dental" structure is formed instead of a grating with conformal TCO. On top of this thick TCO layer, a new random as grown texture 302 is formed on the first layer 108 of TCO similar as prior art random nano-texture.

In order to overcome the defects that can be caused because of the non optimal texture geometry on the layer of curable material 104, the texture on the layer of curable material 104 need to be controlled and optimized to eliminate the defects depicted in FIG. 3. FIG. 4 includes diagrammatic illustration depicting examples of texture 402 that is imprinted on the layer of curable material 104 to eliminate the defects, shown in FIG. 3, in accordance with the current invention. The texture 402 is such that it that enables and enhances light trapping capability of semiconductor layers of the photovoltaic device 100. This texture 402 also helps in scattering and diffraction of the light and thus, enhances the light path through the photovoltaic device 100 and hence, enhances the chance of absorption of light by the semiconductor layers of the photovoltaic device 100. Therefore, the texture 402 can also be called light trapping texture 402 and as this texture 402 is formed on the layer of curable material 104, therefore, the layer 104 can be called light trapping layer. The texture 402 is such that it facilitates growth of the first layer of TCO 108 on the layer of curable material 104, and prevents formation of cracks on subsequent semiconductor layers 110, 112, 114, 116 and 118.

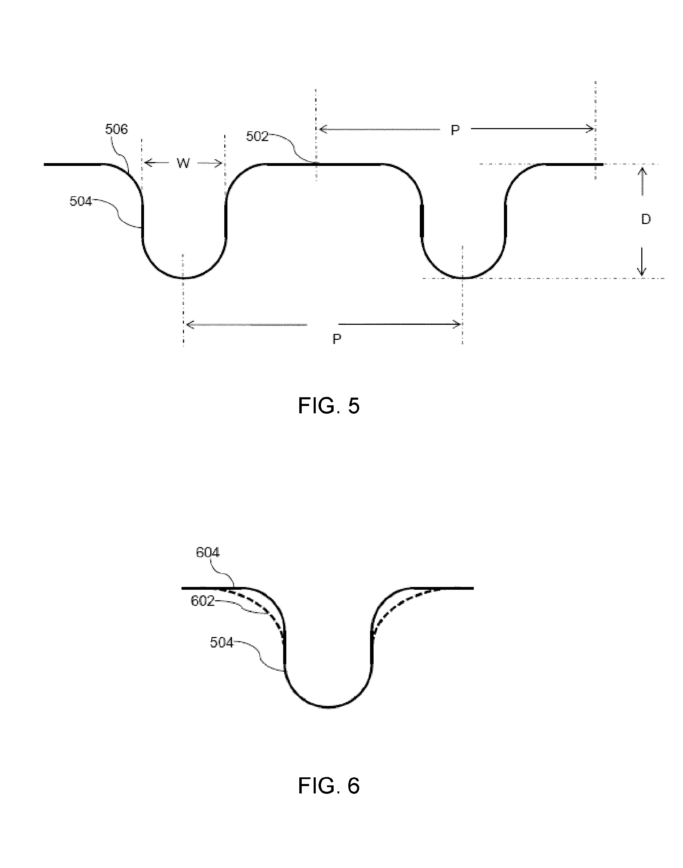

The geometry of the texture 402 is such that it has a plurality of flat areas 502 between a plurality of periodically repeating non-pointed depressions with rounded edges 504 (Refer FIG. 5). The geometry of the texture 402 is such that the plurality of flat areas 502 fall between the non-pointed depressions with rounded edges 504. Further, the flat areas 502 as well as the non-pointed depressions with rounded edges 504 repeat periodically with a period (P) on the surface of the layer of curable material 104 to form the texture 402. Period (P) of both the flat areas 502 and the non-pointed depressions with rounded edges 504 is same as shown in FIG. 5.

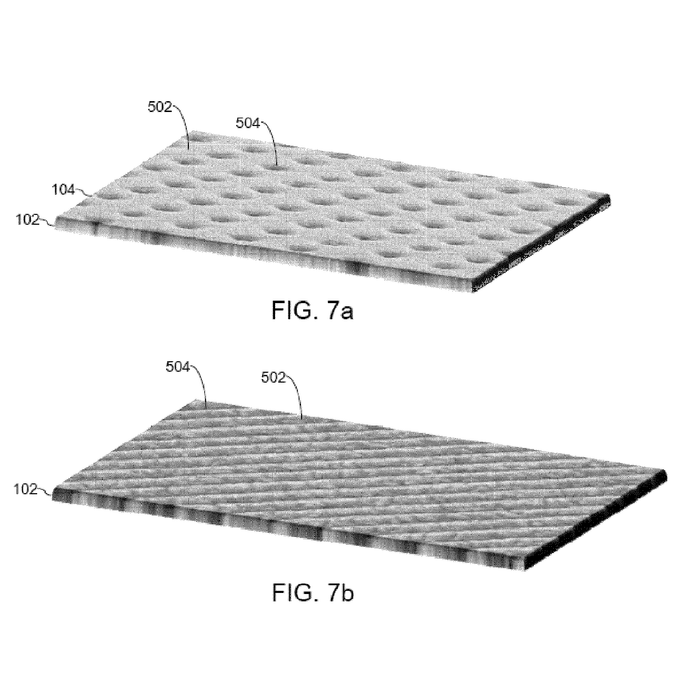

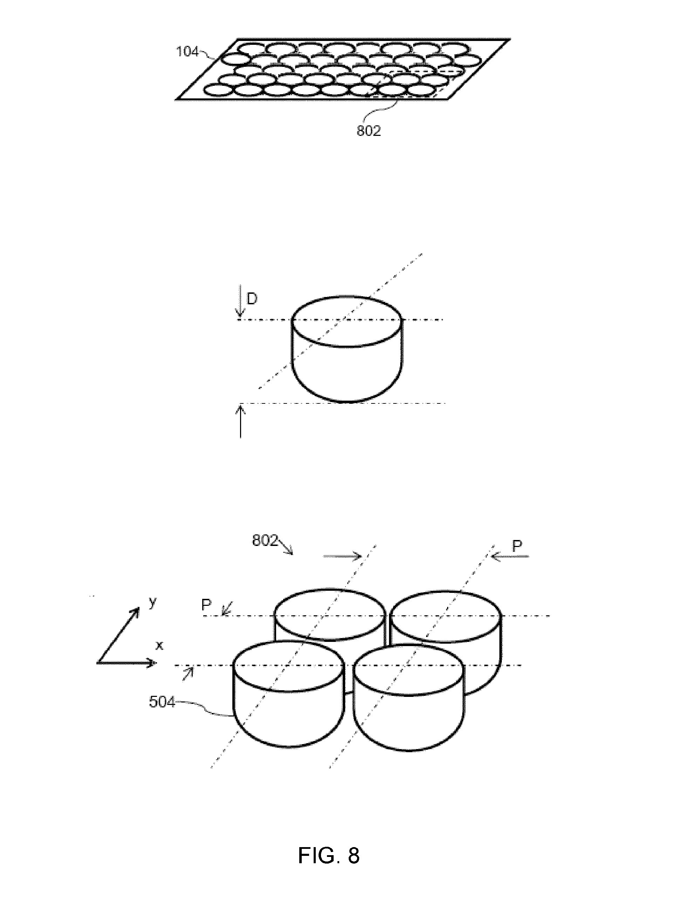

In one embodiment, the plurality of flat areas 502 and the plurality of periodically repeating non-pointed depressions with rounded edges 504 occupy equal area on the layer of curable material 104. In other words, the sum of area occupied by multiple flat areas 502 on the surface of the layer of curable material 104 is equal to the sum of area occupied by multiple non-pointed depressions with rounded edges 504. In one embodiment, the flat areas 502 and the non-pointed depressions 504 can be periodically repeating in 2-Dimensions, i.e. two mutually perpendicular directions on the surface of the layer of curable material 104. A detailed view of this embodiment has been depicted in FIG. 7a and FIG. 8. In another embodiment, the flat areas 502 and the non-pointed depressions 504 can be periodically repeating in 1-Dimension (as shown in FIG. 7b), thus producing U-shaped grooves 504 between substantially flat areas 502 on the surface of the layer of curable material 104.

The geometry of the texture 402 is such that it helps in an improved growth of the first layer 108 of TCO and at the same time, it limits formation of cracks, voids, and low density areas on the subsequent semiconductor layers 110, 112, 114, 116 and 118. Improved growth of the first layer 108 of TCO is achieved because the plurality of substantially flat areas 502 provide a better leveled surface for TCO deposition as compared to the prior art for TCO deposition. Thus, the plurality of substantially flat areas 502 helps in an improved growth of the first layer 108 of TCO by facilitating deposition and growth of the first layer of TCO 108 over it.

The plurality of periodically repeating non-pointed depressions with rounded edges 504 limit formation of cracks, voids, and low density areas on the subsequent semiconductor layers 110, 112, 114, 116 and 118. Normally, cracks, voids, and low density areas are formed on the subsequent semiconductor layers 110, 112, 114, 116 and 118 because the microcrystalline semiconductor layer grows in crystals along the surface normal. When the wall angle of these indentations is too large, the crystals will collide during growth resulting in a crack or low density area. Now, in case of non-pointed depressions with rounded edges 504, crystals don't collide during growth and hence, crack or low density areas are not formed by use of non-pointed depressions with rounded edges 504.

The non-pointed depressions 504 can be of various shapes, such as inverted pyramids, inverted cones or U-shaped depressions among others. The non-pointed depressions with rounded edges 504 are such that curves 506 of the non-pointed depressions 504 are flattened out and these curves 506 meet the flat areas 502 in a manner such that no sharp features are formed on the surface of the layer of curable material 104. Because of these curves, the depressions 504 have non-pointed and round edges. Generally, the curves 506 with greater radius of curvature provide better results. Therefore, in general, rounded curves are preferred instead of sharp edges. To describe this invention, U-shaped non-pointed depressions have been used. However, this would be readily apparent to those skilled in the art that the present invention can be practiced using other shapes of non-pointed depressions 504 , such as inverted pyramids, inverted cones, without deviating from the scope of the invention.

Period (P), depth (D) and duty-cycle or depression width (W) of the non-pointed depressions 504 are dependent on the material of the TCO, thickness of the TCO layer, type of TCO deposition process, type of photovoltaic device 100, and the like. Depending upon the above mentioned parameters, the specific shape, period and depth of the non-pointed depressions 504 can be optimized. For example, if the width of the U-shaped non pointed depressions 504 is increased, it produces very broad depressions. Now, if a layer of TCO is deposited over these very broad U-shaped depressions 504, it results in sufficient wide pit feature for deposition of subsequent semiconductor layers 110, 112, 114, 116 and 118. Also, the curves 602 of the U-shape non-pointed depressions 504 towards the flat plane 604 (as shown in FIG. 6) can be flattened out more to prevent the TCO from narrowing the U-shaped non-pointed depressions 504. Generally, the curves 602 with greater radius of curvature provide better results because the curves 602 with greater radius of curvature prevent the TCO from narrowing the U-shaped non-pointed depressions 504. In case the curves 602 are sharp and pointed, i.e. the radius of curvature of the curves 602 is less, the possibility of flattening out of U-shaped non-pointed depressions 504 increases. Flattening out of U-shaped non-pointed depressions 504 is caused by complete leveling of grating due to TCO growth on the non-wide U-shaped depressions, which results inclusion of voids in the TCO layer. Therefore, in general, rounded curves are preferred instead of sharp edges.

The period (P) of the non-pointed depressions 504 ranges between 100 nanometers and 1500 nanometers, depth (D) of the non-pointed depressions 504 ranges between 50 nanometers and 1200 nanometers, and duty cycle or depression width (W) ranges between ¼ of the period (P) and ¾ of the period (P).

Generally, the range of period (P) of the non-pointed depressions 504 is equal to the wavelength from which light is diffracted. For example, the non-pointed depressions 504 having period (P) of 600 nanometers is capable of diffracting light having wavelength 600 nanometers and below.

The depth (D) of the non-pointed depressions 504 impact the light diffracting and scattering ability of the non-pointed depressions 504 as well as the amount of light reflection. Generally, deeper depressions 504 have an increased ability to diffract and scatter light as compared to shallow depressions 504 and also deeper depressions 504 provide an optimum depth regarding maximum reflection reduction. The reflection is reduced by the gradient in refractive index that occurs from glass/front TCO/semiconductor layers which is caused by the introduction of the non-pointed depressions. The mix or blending of the materials results in an effective medium that optically has a gradient in refractive index from glass to semiconductor layers which can result in a significant reduction of the reflection of the incoming light. The non-pointed depressions 504 having depth (D) less than 50 nanometers become optically non relevant, as these depressions 504 will not be able to sufficiently scatter any light. The upper limit of depth of the non-pointed depressions 504 is limited by the mechanical problem in manufacturing these depressions 504. It is difficult to manufacture very deep depressions 504 having depth (D) greater than 1200 nanometers due to the large aspect ratio of the depressions 504.

The period (P) of the non-pointed depressions 504, depth (D) of the non-pointed depressions 504, and duty cycle or depression width (W) is different for CdTe solar cells, CIGS solar cells, Organic PV solar cells, a-Si:H solar cells, µc-Si:H solar cells, and a-Si:H/µc-Si:H tandem solar cells. For example, in case the photovoltaic device 100 is a a-Si:H solar cell, the period (P) of the non-pointed depressions 504 ranges between 100 nanometers and 1000 nanometers, and depth (D) of the non-pointed depressions 504 ranges between 50 nanometers and 500 nanometers. In another example, when the photovoltaic device 100 is a µc-Si:H solar cell, the period (P) of the non-pointed depressions 504 ranges between 500 nanometers and 1500 nanometers, and the depth (D) of the non-pointed depressions 504 ranges between 50 nanometers and 1200 nanometers. In yet another example, when the photovoltaic device 100 is a a-Si:H/µc-Si:H tandem solar cell, the period (P) of the non-pointed depressions 504 ranges between 500 nanometers and 1500 nanometers, and the depth of the non-pointed depressions 504 ranges between 50 nanometers and 1200 nanometers. As mentioned above the chosen period range for each type of solar cell depends on the wavelength of light absorbed by these different absorber materials. For example, a-Si solar cells absorb light having wavelength between 300 nanometers to 800 nanometers. Based on this, an upper limit of 1000 nanometers and a lower limit of 100 nanometers have been selected for a-Si solar cells. In a similar manner, µc-Si solar cells and a-Si/µc-Si solar cells, absorbs light having wavelength between 300 nanometers and 1200 nanometers, therefore an upper limit of 1500 nanometers should be sufficient. For µc-Si it is important to scatter the longer wavelengths, therefore scattering light with wavelengths below 500 nanometers is not required, hence the lower limit for the period has been set to 500 nanometers.

Generally, the value of period (P) corresponds to the bandgap of the absorber materials, namely 1.7 eV for a-Si:H solar cell and 1.1 eV for µc-Si:H solar cell. Further, the bandgap of the absorber materials corresponds to an upper wavelength sensitivity of approximately 800nm and 1200nm for respectively a-Si:H solar cell and µc-Si:H solar cell.

In one embodiment, as shown in FIG. 7a, the non-pointed depressions 504 are periodically repeating in 2-Dimensions, i.e. two mutually perpendicular directions on the surface of the layer of curable material 104. A more detailed view of this embodiment has been depicted in FIG. 8. As shown in FIG. 8, the layer of curable material 104 has a 2-dimensional texture of non-pointed depressions 504. An area 802 of the layer of curable material 104 shows the texture of the layer of curable material 104 in more detail. As shown with help of the area 802 of the layer of curable material 104, the period (P) of the non-pointed depressions 504 ranges between 50 nanometers and 1500 nanometers. In this embodiment, the period (P) of the non-pointed depressions 504 is equal in both the dimensions. However, those skilled in the art would appreciate that the period of the non-pointed depressions 504 can be different in different dimensions. For example, the period of the non-pointed depressions 504 can be P1 along x-axis and the period of the non-pointed depressions 504 can be P2 along y-axis. The depth (D) of the non-pointed depressions 504 ranges between 100 nanometers and 1200 nanometers. In another embodiment, the non-pointed depressions 504 can be periodically repeating in 1-Dimension (as shown in FIG. 7b), thus producing U-shaped grooves 504 between substantially flat areas 502 on the surface of the layer of curable material 104. In this embodiment, the range of period (P) and the depth (D) of the non-pointed depressions 504 remain the same as mentioned above. In yet another embodiment, the non-pointed depressions 504 can be periodically repeating directions on the surface of the layer of curable material 104 to form a honey comb structure.

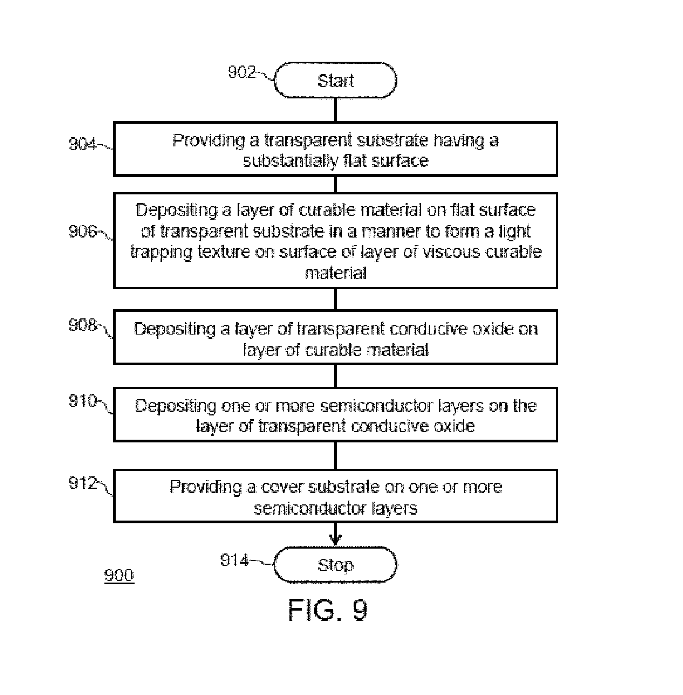

Moving on to FIG. 9, FIG. 9 is a flow chart describing an exemplary method 900 for manufacturing the photovoltaic device 100 in accordance with an embodiment of the present invention. To describe the method 900, reference will be made to FIG. 1, although it is understood that the method 900 can be implemented to manufacture any other suitable device. Moreover, the invention is not limited to the order of in which the steps are listed in the method 900. In addition, the method 900 can contain a greater or fewer numbers of steps than those shown in FIG. 9.

The method 900 for manufacturing the photovoltaic device 100 is initiated at step 902. At step 904, the substrate 102 is provided. As described in conjunction with FIG. 1, the substrate 102 provides strength to the photovoltaic device 100 and is used as a starting point for deposition of the photovoltaic device 100. The substrate 102 is transparent in nature and can be made of materials such as glass and transparent plastic. The substrate 102 is made of a transparent material so that it can allow maximum light to pass through itself and reach the subsequent semiconductor layers. Further, the substrate 102 includes a substantially flat surface on which other layers of the photovoltaic device 100 can be deposited.

Following this, at step 906, the layer of curable material 104 is deposited on the flat surface of the substrate 102. The curable material can be deposited by using a brush or roller, dispensing, slot dye coating, screen printing, spin-coating, spray coating or printing. The viscous curable material can include, but is not limited to, an ultra-violet curable material, a photo-polymer lacquer, an acrylate, and a sol-gel material. The layer of the curable material 104 is deposited in a manner such that a texture is formed on surface of the layer of the curable material 104. This texture is such that it that enables and enhances the light trapping capability of the semiconductor layers of the photovoltaic device 100. This texture helps in scattering and diffraction of the light and thus, enhances the light path through the photovoltaic device 100 and hence, enhances the chance of absorption of light by the semiconductor layers of the photovoltaic device 100. Therefore, the texture can also be called light trapping texture and as this texture is formed on the layer of curable material 104, therefore, the layer 104 can be called light trapping layer. The texture is such that it facilitates growth of the first layer of TCO 108 on the layer of curable material 104, and prevents formation of cracks on subsequent semiconductor layers 110, 112, 114, 116 and 118.

The geometry of the texture is such that it has a plurality of flat areas between a plurality of periodically repeating non-pointed depressions with rounded edges. The plurality of substantially flat areas helps in an improved growth of the first layer 108 of TCO by facilitating deposition and growth of the first layer of TCO 108 over it. The plurality of periodically repeating non-pointed depressions with rounded edges limit formation of cracks, voids, and low density areas on the subsequent semiconductor layers 110, 112, 114, 116 and 118. The non-pointed depressions can be of various shapes, such as inverted pyramids, inverted cones or U-shaped depressions among others. Various examples of the geometry of the texture have been described in conjunction with FIGs. 4, 5, 6, 7a, 7b, and 8.

At step 908, the first layer 108 of TCO is deposited on the layer of the curable material 104. Thereafter, at step 910, multiple semiconductor layers are deposited on the first layer 108 of TCO. These multiple semiconductor layers can include the first layer of p-doped semiconductor 110, the second layer of p-doped semiconductor 112, the layer of buffer 114, the layer of i-doped semiconductor 116, and the layer of n-doped semiconductor 118. As described in conjunction with FIG. 1, the semiconductor layers are deposited in a manner that they form a pi-n structure.

Following this, at step 912, the cover substrate is provided on the multiple semiconductor layers. The cover substrate can include the second layer 120 of TCO, the layer 122 of silver, and the layer 124 of aluminum. The method 900 is terminated at step 914.

Various embodiments, as described above, provide a light trapping layer for use in a thin film solar cell, which has several advantages. One of the several advantages of some embodiments of this method is that it facilitates deposition and growth of the layer of transparent conductive oxide over the light trapping layer. Another advantage of this invention is that it improves and enhances the efficiency and quality of the thin film solar cells. Furthermore, the disclosed light trapping layer limits formation of cracks, voids, and low density areas in semiconductor layers of the thin film solar cells.

While the invention has been disclosed in connection with the preferred embodiments shown and described in detail, various modifications and improvements thereon will become readily apparent to those skilled in the art. Accordingly, the present invention is not to be limited by the foregoing examples, but is to be understood in the broadest sense of the claims.

All documents referenced herein are hereby incorporated by reference.

## Claims

1. A light trapping layer (104) for use in a thin film solar cell, said light trapping layer enhances efficiency of said thin film solar cell, wherein said light trapping layer (104) having a plurality of substantially flat areas (502) between a plurality of periodically repeating non-pointed depressions with rounded edges (504), wherein said plurality of substantially flat areas (502) facilitate deposition and growth of a layer (108) of transparent conductive oxide over said light trapping layer (104), **characterized in that** said plurality of periodically repeating non-pointed depressions with rounded edges (504) limit formation of at least one of cracks, voids, and low density areas in semiconductor layers of said thin film solar cell, further wherein period of said non-pointed depressions (504) ranges between 100 nanometers and 1500 nanometers, and depth of said non-pointed depressions (504) ranges between 50 nanometers and 1200 nanometers.

2. The light trapping layer (104) according to claim 1, wherein said non-pointed depressions (504) are selected from the group comprising inverted pyramids, inverted cones and U-shaped depressions.

3. The light trapping layer (104) according to claim 1 or 2, wherein said non-pointed depressions (504) are periodically repeating in two mutually perpendicular directions on the surface of said layer (104) of said curable material.

4. The light trapping layer (104) according to one of claims 1 to 3, wherein said thin film solar cell is a a-Si:H solar cell, further wherein period of said non-pointed depressions (504) ranges between 100 nanometers and 1000 nanometers, and depth of said non-pointed depressions (504) ranges between 50 nanometers and 500 nanometers.

5. The light trapping layer (104) according to one of claim 1 to 3, wherein said thin film solar cell is a µc-Si:H solar cell, further wherein period of said non-pointed depressions (504) ranges between 500 nanometers and 1500 nanometers, and depth of said non-pointed depressions (504) ranges between 50 nanometers and 1200 nanometers.

6. The light trapping layer (104) according to one of claim 1 to 3, wherein said thin film solar cell is a a-Si:H/µc-Si:H tandem solar cell, further wherein period of said non-pointed depressions (504) ranges between 500 nanometers and 1500 nanometers, and depth of said non-pointed depressions (504) ranges between 50 nanometers and 1200 nanometers.

7. The light trapping layer (104) according to one of claim 1 to 6, wherein material of said light trapping layer (104) is selected from the group comprising an acrylate, an ultra-violet curable material, a photo-polymer lacquer and a sol-gel material.
